# EUROPEAN PATENT APPLICATION

(11) **EP 3 854 916 A1**
(43) Date of publication of application: **28.07.2021**
(21) Application number: 19862939.6
(22) Date of filing: 19.09.2019
(51) Int. Cl.: C30B 29/36, C30B 33/02, H01L 21/265, H01L 21/324

(54) **METHOD FOR MANUFACTURING DEVICE FABRICATION WAFER**

(30) Priority: 21.09.2018 JP 2018178074; 06.11.2018 JP 2018209202
(71) Applicant: Toyo Tanso Co., Ltd., Osaka-shi, Osaka 555-0011 (JP)
(72) Inventor: YABUKI, Norihito, Kanonji-shi, Kagawa 769-1612 (JP); SAKAGUCHI, Takuya, Kanonji-shi, Kagawa 769-1612 (JP); JINNO, Akiko, Kanonji-shi, Kagawa 769-1612 (JP); NOGAMI, Satoru, Kanonji-shi, Kagawa 769-1612 (JP); KITABATAKE, Makoto, Kanonji-shi, Kagawa 769-1612 (JP)
(74) Representative: TBK
(86) International application number: PCT/JP2019/036803
(87) International publication number: WO 2020/059810

(57) **Abstract**

In a method for manufacturing a device fabrication wafer 43, an SiC epitaxial wafer 42 that is an SiC wafer 40 having a monocrystalline SiC epitaxial layer 41 formed thereon is subjected to a basal plane dislocation density reduction step of reducing the density of basal plane dislocations existing in the epitaxial layer of the SiC epitaxial wafer 42, to thereby manufacture the device fabrication wafer 43 for use to fabricate a semiconductor device. In the basal plane dislocation density reduction step, the SiC epitaxial wafer 42 is heated under Si vapor pressure for a predetermined time necessary to reduce the density of basal plane dislocations, without formation of a cap layer on the SiC epitaxial wafer 42, so that the density of basal plane dislocations is reduced with suppression of surface roughening.

## Description

### Technical Field

The present invention mainly relates to a method for reducing the density of basal plane dislocations in an epitaxial layer by performing a basal plane dislocation density reduction step on an SiC epitaxial wafer.

### Background Art

Conventionally known is the fact that if there is basal plane dislocations in an SiC epitaxial wafer, a semiconductor device fabricated by using the SiC wafer is likely to have a deteriorated electricity conduction performance. A method for reducing the density of basal plane dislocations is disclosed by Patent Literature 1 (PTL 1).

PTL 1 shows forming a carbon cap on an SiC epitaxial wafer and heating it at a temperature higher than 1750°C and lower than 1875°C for example, to thereby reduce the density of basal plane dislocations in an epitaxial layer.

Patent Literature 2 (PTL 2) shows a method in which an SiC epitaxial wafer having an epitaxial layer implanted with ions is heated under Si vapor pressure, for ion activation and surface planarization.

Non-Patent Literature 1 (NPL 1) shows a result of comparison between the surface roughness without presence of a carbon cap and the surface roughness with presence of a carbon cap. According to NPL 1, forming the carbon cap reduces the surface roughness of a wafer.

### Citation List

### Patent Literature

PTL 1: Japanese Translation of PCT International Application Publication No. 2017-517138
PTL 2: Japanese Patent Application Laid-Open No. 2014-101238

### Non-Patent Literature

NPL 1: T. Kimoto et al, "Fundamentals of Silicon Carbide Technology", 2014, Wiley-IEEE Press, pp.201-203

### Summary of Invention

### Technical Problem

Heating an SiC epitaxial wafer without forming a cap layer to reduce the density of basal plane dislocations involves occurrence of surface roughening. Forming a cap layer as disclosed in PTL 1 or NPL 1, however, requires a step of forming the cap layer and a step of removing the cap layer, which results in a longer time taken for a process. In addition, depending on conditions, the surface roughening may not be prevented even though the cap layer is formed, or the cap layer may react with the epitaxial layer. PTL 2 neither discloses nor suggests a process for reducing the density of basal plane dislocations.

The present invention is made in view of the circumstances described above, and primarily aims to provide a method for reducing the density of basal plane dislocations in an SiC epitaxial wafer without forming a cap layer and with suppression of surface roughening.

### Solution to Problem and Advantageous Effects Thereof

The problem to be solved by the present invention is as stated above. In the following, solutions to the problem as well as advantageous effects thereof will be described.

An aspect of the present invention provides a method for manufacturing a device fabrication wafer, as follows. In the manufacturing method, a device fabrication wafer for use to fabricate a semiconductor device is manufactured by subjecting an SiC epitaxial wafer that is an SiC wafer having a monocrystalline SiC epitaxial layer formed thereon to a basal plane dislocation density reduction step of reducing the density of basal plane dislocations existing in the epitaxial layer of the SiC epitaxial wafer. In the basal plane dislocation density reduction step, the SiC epitaxial wafer is heated under Si vapor pressure for a predetermined time necessary to reduce the density of basal plane dislocations, without formation of a cap layer on the SiC epitaxial wafer, so that the density of basal plane dislocations is reduced with suppression of surface roughening.

Since the SiC epitaxial wafer is heated under Si vapor pressure, surface roughening is less likely to occur. A cap layer is not necessary in the basal plane dislocation density reduction step, therefore. Accordingly, steps related to formation and removal of a cap layer can be eliminated, while surface roughening of the SiC epitaxial wafer can be suppressed.

The method for manufacturing the device fabrication wafer is preferably configured as follows. The method for manufacturing the device fabrication wafer includes an ion implantation step, and an activation and planarization step. In the ion implantation step, ions are implanted in the SiC epitaxial wafer. In the activation and planarization step, the SiC epitaxial wafer having been implanted with the ions in the ion implantation step is heated under Si vapor pressure, so that the ions are activated while a surface of the SiC epitaxial wafer is planarized. The basal plane dislocation density reduction step is a step separate from the activation and planarization step.

With this, the basal plane dislocation density reduction step can be performed under conditions particularly suitable for removal of basal plane dislocations. Activation by heating under Si vapor pressure is performed after ion implantation. Accordingly, even with a large amount of implanted ions or a high heating temperature in activation, it is possible to improve electrical characteristics with suppression of increase of surface roughness.

In the method for manufacturing the device fabrication wafer, it is preferable that the basal plane dislocation density reduction step is performed before the ion implantation step.

Since the basal plane dislocation density reduction step is performed before properties of the epitaxial layer are changed by ion implantation, basal plane dislocations can be removed further reliably.

In the method for manufacturing the device fabrication wafer, it is preferable that a temperature in the basal plane dislocation density reduction step is higher than a temperature in the activation and planarization step.

Accordingly, the basal plane dislocation density reduction step can be performed at a relatively high temperature that is adapted for sufficient reduction of the density of basal plane dislocations.

In the method for manufacturing the device fabrication wafer, it is preferable that an etching rate in the basal plane dislocation density reduction step is lower than an etching rate in the activation and planarization step.

This can prevent excessive removal of the epitaxial layer of the SiC epitaxial wafer in the basal plane dislocation density reduction step.

The method for manufacturing the device fabrication wafer is preferably configured as follows. The method includes an ion implantation step of implanting ions in the SiC epitaxial wafer. The basal plane dislocation density reduction step is performed after the ion implantation step. In the basal plane dislocation density reduction step, activation of the ions implanted in the ion implantation step as well as planarization of a surface of the SiC epitaxial wafer is further performed.

This can reduce the number of steps. In addition, activation by heating under Si vapor pressure is performed after ion implantation. Accordingly, even with a large amount of implanted ions or a high heating temperature in activation, it is possible to improve electrical characteristics with suppression of increase of surface roughness.

In the method for manufacturing the device fabrication wafer, it is preferable that the SiC epitaxial wafer has an off angle of 4 degrees or less relative to the <11-20> direction or the <1-100> direction.

This can more reliably suppress an increase in surface roughness at a time of ion activation.

In the method for manufacturing the device fabrication wafer, it is preferable that a temperature in the basal plane dislocation density reduction step is 1950°C or more and 2200°C or less.

This allows the density of basal plane dislocations to be reduced sufficiently.

In the method for manufacturing the device fabrication wafer, it is preferable that the basal plane dislocation density reduction step is performed with a processing environment and a processing time that bring a surface roughness (Ra) of the device fabrication wafer to 0.4 nm or less after the basal plane dislocation density reduction step.

This makes it highly likely that a step bunching is not generated on the device fabrication wafer, and thus the device fabrication wafer with a high quality can be manufactured.

In the method for manufacturing the device fabrication wafer, it is preferable that the density of basal plane dislocations in the epitaxial layer of the SiC epitaxial wafer is reduced by 97% or more as a result of the basal plane dislocation density reduction step.

Accordingly, the device fabrication wafer having a very small amount of basal plane dislocations can be manufactured.

### Brief Description of Drawings

[FIG. 1] A diagram for explaining an overview of a high temperature vacuum furnace that is used in, for example, a basal plane dislocation density reduction step of the present invention.
[FIG. 2] A diagram schematically showing a process performed on a wafer according to an embodiment.
[FIG. 3] A diagram showing dislocation directions of a TED and a BPD.
[FIG. 4] Enlarged views showing PL imaging measurement results obtained after the basal plane dislocation density reduction step was performed at 1800°C.
[FIG. 5] Enlarged views showing PL imaging measurement results obtained after the basal plane dislocation density reduction step was performed at 1900°C.
[FIG. 6] Enlarged views showing PL imaging measurement results obtained after the basal plane dislocation density reduction step was performed at 2000°C.
[FIG. 7] A diagram showing changes in the number of BPDs observed by PL imaging measurement on wafers that had undergone the basal plane dislocation density reduction step at different temperatures, respectively.
[FIG. 8] A graph showing the relationship between the temperature in the basal plane dislocation density reduction step and the rate of BPD reduction.
[FIG. 9] A first diagram showing that a surface roughness of more than 0.4 nm causes generation of a step bunching in a wafer.
[FIG. 10] A second diagram showing that a surface roughness of more than 0.4 nm causes generation of a step bunching in a wafer.
[FIG. 11] A diagram schematically showing a process of performing the basal plane dislocation density reduction step after an ion implantation step.
[FIG. 12] Graphs showing the value of the surface roughness relative to the amount of implanted ions and the heating temperature, in a case where ions were activated with a cap layer formed.
[FIG. 13] A graph showing the value of the surface roughness relative to the amount of implanted ions and the heating temperature, in a case where ions were activated by heating under Si vapor pressure.
[FIG. 14] A diagram showing results of observing wafer surfaces with a coherence scanning interferometer, under the conditions of A, B, and C indicated in FIG 12 and FIG. 13.

### Description of Embodiments

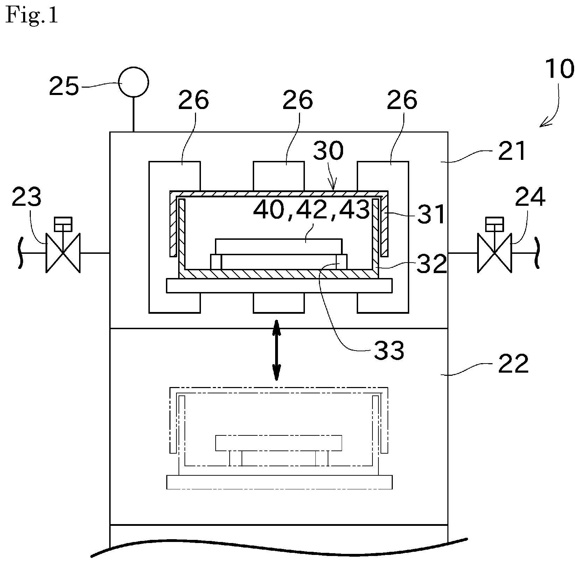

An embodiment of the present invention will be described with reference to the drawings. First, referring to FIG. 1, a description will be given to a high temperature vacuum furnace 10, which is used in, for example, a method for manufacturing monocrystalline SiC of the embodiment.

As shown in FIG. 1, the high temperature vacuum furnace 10 includes a main heating chamber 21 and a preheating chamber 22. The main heating chamber 21 is capable of heating a processing object at a temperature of 1000°C or more and 2300°C or less. A wafer as the processing object is an SiC wafer 40, at least a surface of which is made of monocrystalline SiC (e.g., 4H-SiC or 6H-SiC), or an SiC epitaxial wafer 42, which is the SiC wafer 40 having a monocrystalline SiC epitaxial layer 41 formed thereon. The preheating chamber 22 defines a space where the SiC wafer 40 or the like is preheated before being heated in the main heating chamber 21.

Connected to the main heating chamber 21 are a vacuum creation valve 23, an inert gas injection valve 24, and a vacuum gauge 25. The vacuum creation valve 23 is capable of adjusting the degree of vacuum in the main heating chamber 21. The inert gas injection valve 24 is capable of adjusting the pressure of an inert gas in the main heating chamber 21. In this embodiment, the inert gas is a gas of a Group 18 element (rare gas element) such as Ar, that is, a gas having a poor reactivity with an SiC solid, excluding a nitrogen gas. The vacuum gauge 25 is capable of measuring the degree of vacuum in the main heating chamber 21.

Heaters 26 are provided inside the main heating chamber 21. A heat-reflective metal plate (not shown) is fixed to a side wall and a ceiling of the main heating chamber 21. The heat-reflective metal plate is configured to reflect heat of the heaters 26 toward the center of the main heating chamber 21. This allows the SiC wafer 40, and the like, to be strongly and uniformly heated up to a temperature of 1000°C or more and 2300°C or less. A heater of resistance heating type or high-frequency induction heating type is adoptable as the heater 26, for example.

The high temperature vacuum furnace 10 heats the SiC wafer 40 or the like received in a crucible (receiving container) 30. The receiving container 30 is placed on an appropriate support base, for example. As the support base moves, the receiving container 30 is allowed to move at least from the preheating chamber to the main heating chamber. The receiving container 30 includes an upper container 31 and a lower container 32 that are fittable to each other. The lower container 32 of the receiving container 30 is provided with a supporter 33 that is capable of supporting the SiC wafer 40 or the like so as to expose both the principal plane and the back plane of the SiC wafer 40 or the like. The principal plane of the SiC wafer 40 or the like is an Si plane, and in terms of crystal plane, is a (0001) plane. The back plane of the SiC wafer 40 or the like is a C plane, and in terms of crystal plane, is a (000-1) plane. The SiC wafer 40 or the like may have an off angle relative to the Si plane or the C plane. More specifically, the SiC wafer 40 or the like may have an off angle of, for example, 4 degrees or less relative to the <11-20> direction or the <1-100> direction. It may be acceptable that the C plane serves as the principal plane. Here, the principal plane means one of the two surfaces (the upper and lower surfaces in FIG. 1) having the largest areas among surfaces of the SiC wafer 40 or the like. On the one of the two surfaces, an epitaxial layer is formed in a later step. The back plane is the plane opposite to the principal plane.

A portion of the receiving container 30 constituting a wall surface (upper, side, and bottom surfaces) defining an internal space where the SiC wafer 40 or the like is received is made of a tantalum layer (Ta), a tantalum carbide layer (TaC and Ta₂C), and a tantalum silicide layer (TaSi₂ or Ta₅Si₃, etc.), in this order from outside toward the internal space.

The tantalum silicide layer, when heated, supplies Si to the internal space of the receiving container 30. Since the receiving container 30 has the tantalum layer and the tantalum carbide layer, it is possible to take in ambient C vapor. As a result, a high-purity Si atmosphere can be created in the internal space when heating. Instead of the tantalum silicide layer, an Si source such as an Si solid may be disposed in the internal space. With such a configuration, the Si solid is sublimated by heating, to allow the inside of the internal space to be under high-purity Si vapor pressure.

To heat the SiC wafer 40 or the like, firstly, the receiving container 30 is arranged in the preheating chamber 22 of the high temperature vacuum furnace 10 as indicated by the dot and dash lines in FIG. 1, and is preheated at an appropriate temperature (e.g., about 800°C). Then, the receiving container 30 is moved to the main heating chamber 21, which has been preliminarily heated up to a set temperature (e.g., about 1800°C). Then, with adjustment of the pressure and the like, the SiC wafer 40 or the like is heated. The preheating may be omitted.

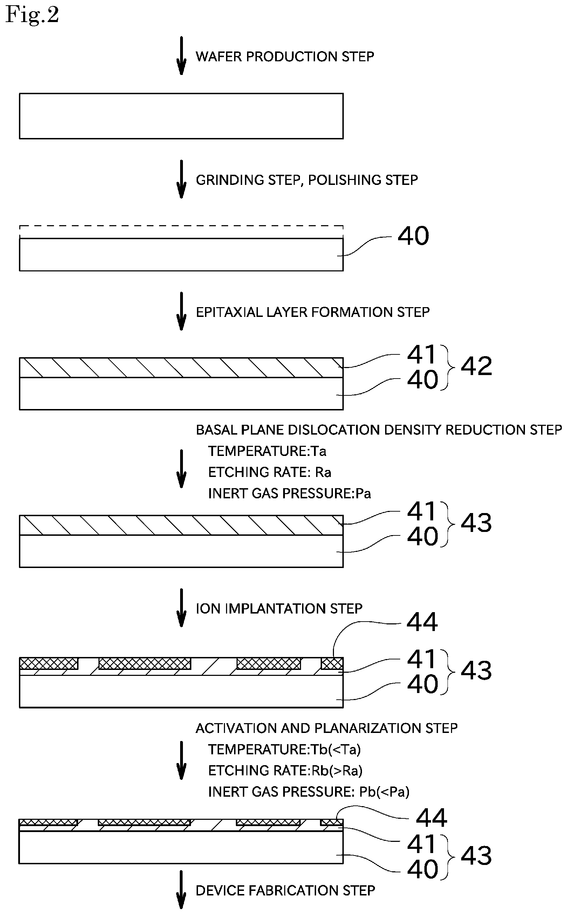

Next, referring to FIG. 2, a process performed on the SiC wafer 40 will be described. FIG. 2 is a diagram schematically showing the process performed on the SiC wafer 40 according to this embodiment.

The SiC wafer 40 is produced from an ingot. The ingot is a monocrystalline SiC block produced by a known sublimation process or solution growth process, for example. Cutting means as exemplified by a diamond wire is used to cut the SiC ingot at predetermined intervals, thereby producing a plurality of SiC wafers 40 from the ingot (wafer production step). The SiC wafer 40 has a disk-like shape, for example. FIG. 2 schematically shows a cross-section of the SiC wafer 40 as cut along its thickness direction.

Another method may be adopted to produce the SiC wafer 40. For example, it is possible to form a damage layer on the ingot by laser irradiation, etc., and then take out a portion in the shape of a wafer. It is also possible to laminate a monocrystalline SiC substrate and a polycrystalline SiC substrate obtained from an ingot or the like to each other, and then perform a process such as peeling as needed, thereby producing an SiC wafer, at least a surface of which is made of monocrystalline SiC.

Then, the SiC wafer 40 is subjected to a grinding step and a polishing step. In the grinding step, for example, a process (grinding) of mechanically grinding at least the principal plane of the SiC wafer 40 with a diamond wheel or the like is performed. In the polishing step, for example, chemical-mechanical polishing or the like is performed to polish at least the principal plane of the SiC wafer 40. The grinding step and the polishing step may be implemented by chemical etching such as Si vapor pressure etching, which will be described later.

Then, the SiC wafer 40 is subjected to an epitaxial layer formation step. In the epitaxial layer formation step, for example, a solution growth process such as MSE process (metastable solvent epitaxy process) or CVD (chemical vapor deposition) is performed to form the epitaxial layer 41 on the principal plane of the SiC wafer 40. In the MSE process, a seed substrate made of polycrystalline SiC, etc., a feed substrate made of monocrystalline SiC, etc., which has a higher free energy than the seed substrate, and an Si melt are used. The seed substrate and the feed substrate are arranged opposed to each other with the Si melt interposed therebetween, and in such a state, are heated under vacuum, so that the monocrystalline SiC epitaxial layer 41 grows on a surface of the seed substrate. In the CVD, the SiC wafer 40 is disposed in a processing apparatus such as a susceptor, and a source gas is introduced in a high temperature environment, so that the monocrystalline SiC epitaxial layer 41 grows on the SiC wafer 40. As mentioned above, the SiC wafer 40 having the epitaxial layer 41 formed thereon is the SiC epitaxial wafer 42.

Then, the SiC epitaxial wafer 42 is subjected to a basal plane dislocation density reduction step. In the basal plane dislocation density reduction step, the SiC epitaxial wafer 42 is heated under Si vapor pressure, and thereby the density of basal plane dislocations in the epitaxial layer of the SiC epitaxial wafer 42 is reduced.

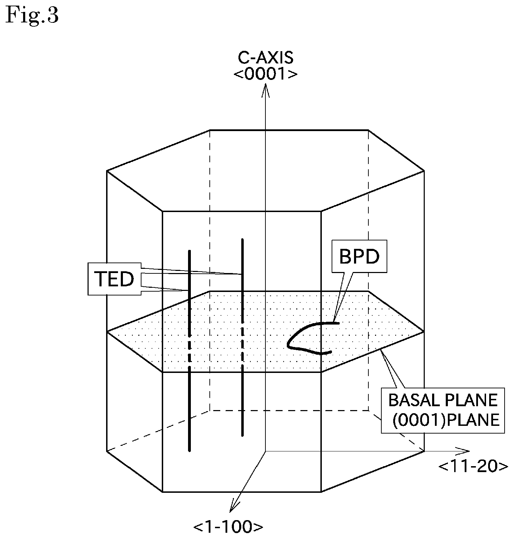

Here, before a detailed description of the basal plane dislocation density reduction step, the basal plane dislocation will be described with reference to FIG. 3. In the following descriptions, the basal plane dislocation will be referred to as BPD. The BPD is an abbreviation of Basal Plane Dislocation.

The BPD encompasses a BPD in a wide sense and a BPD in a narrow sense. In the Description herein, the BPD basically means the BPD in the wide sense, unless indicated otherwise. The BPD in the wide sense encompasses the four kinds of dislocations described below.

A first kind of the BPD in the wide sense is a dislocation having a Burgers vector of b=<11-20>/3, which is a BPD as a perfect dislocation. The first kind of dislocation corresponds to the BPD in the narrow sense. As for a direction of the dislocation, the dislocation is parallel in the (0001) plane of SiC, as shown in FIG. 3. This (0001) plane corresponds to a basal plane. The first kind of dislocation is stable in the <11-20> direction. That is, the first kind of dislocation is stable in six directions of [11-20], [-1-120], [-2110], [2-1-10], [-12-10], and [1-210]. Accordingly, the first kind of dislocation is divided into six types (among which first and second types are substantially the same, third and fourth types are substantially the same, and fifth and sixth types are substantially the same; and given that substantially the same types are considered as one type, the first kind of dislocation is divided into three types).

A second kind of the BPD in the wide sense is a dislocation (Shockley type defect) that is present in the basal plane, obtained by breaking the first kind of dislocation into two Shockley partial dislocations having a Burgers vector of b=<1-100>/3. A third kind of the BPD in the wide sense is a partial dislocation of a Frank type defect in which the above-described Burgers vector b contains a c-component. A fourth kind of the BPD in the wide sense is a partial dislocation that is present at the boundary between a stacking fault and a perfect crystal.

With a high BPD density, the electricity conduction performance of a semiconductor device is likely to deteriorate. A TED (threading edge dislocation) is a type of dislocation that is parallel to the <0001> direction of SiC, as shown in FIG. 3. Thus, the TED is formed perpendicularly through the basal plane. The TED is considered as not influential to the performance of a semiconductor device.

As a result of heating the SiC epitaxial wafer 42, a distal end of a BPD existing on a surface of the SiC epitaxial wafer 42 turns into a TED. As this TED slips in the basal plane, the BPD is shortened, and consequently the BPD is removed from the surface of the SiC epitaxial wafer 42. To obtain sufficient slipping of the TED in the basal plane, a high energy is needed. It therefore is preferable that the temperature in the basal plane dislocation density reduction step is raised.

Heating the SiC epitaxial wafer 42 at a high temperature causes detachment of Si from the surface, to roughen the surface. In this respect, however, forming a cap layer on the surface for the purpose of preventing Si detachment requires a step of forming the cap layer and a step of removing the cap layer, which results in a longer time taken for a process. In addition, depending on conditions, the surface roughening may not be prevented even though the cap layer is formed, or the cap layer may react with the epitaxial layer. Considering the foregoing, this embodiment implements the basal plane dislocation density reduction step by heating the SiC epitaxial wafer 42 under Si vapor pressure, without the step of forming a cap layer.

In this embodiment, the basal plane dislocation density reduction step is implemented by means of an Si vapor pressure etching in which the SiC epitaxial wafer 42 is heated under Si vapor pressure. To be specific, the SiC epitaxial wafer 42 is received in the receiving container 30, and is heated under Si vapor pressure at a high temperature (a specific temperature will be given later) by using the high temperature vacuum furnace 10. In this heating, not only Si vapor but also another inert gas may be supplied. Supplying the inert gas can lower the rate of etching the SiC epitaxial wafer 42. Except for the Si vapor and the inert gas, no vapor source is used. Heating the SiC epitaxial wafer 42 under such conditions causes the surface etching with planarization. More specifically, the following reaction occurs. In short, as a result of heating the SiC epitaxial wafer 42 under Si vapor pressure, SiC in the SiC epitaxial wafer 42 is thermally decomposed and chemically reacts with Si, to turn into Si₂C, SiC₂, or the like, which then is sublimated, while Si existing in the Si atmosphere is bonded to C on the surface of the SiC epitaxial wafer 42, to cause self-organization and thus planarization.
(1) SiC(s) → Si(v) + C(s)
(2) 2SiC(s) → Si(v) + SiC₂(v)
(3) SiC(s) + Si(v) → Si₂C(v)

Accordingly, in a case of performing the Si vapor pressure etching, even if Si detachment was caused, self-organization would occur so that the flatness of the surface of the SiC epitaxial wafer 42 could be maintained or improved. This is why forming a cap layer is not necessary in the basal plane dislocation density reduction step. In this manner, BPDs in the epitaxial layer of the SiC epitaxial wafer 42 are reduced. A length of time over which the basal plane dislocation density reduction step is performed is prescribed in consideration of experiments, processing conditions, and the like. Hereinafter, the SiC epitaxial wafer 42 having undergone the basal plane dislocation density reduction step may be referred to as a device fabrication wafer 43.

Then, the device fabrication wafer 43 is subjected to an ion implantation step. In the ion implantation step, an ion implantation apparatus having a function for implanting ions in an object is used to implant ions in the device fabrication wafer 43. Consequently, ions (e.g., aluminum ions) as impurities are selectively implanted in the whole or part of the surface of the device fabrication wafer 43 (specifically, the epitaxial layer 41).

As a result of the ion implantation, ion implanted regions 44 are formed on the device fabrication wafer 43. In general, a region having an insufficient ion concentration is present near a surface of each ion implanted region 44, though it depends on energy of the implanted ions, etc.

Then, the device fabrication wafer 43 is subjected to an activation and planarization step. In the activation and planarization step, the Si vapor pressure etching described above is performed. The Si vapor pressure etching, which is performed at a high temperature, causes the ions implanted in the device fabrication wafer 43 to be activated. As a result of etching performed in the activation and planarization step, the region having the insufficient ion concentration, which is present on the surface of the device fabrication wafer 43, is removed. Even when the device fabrication wafer 43 has a step bunching (which means a step formed by a plurality of SiC layers bunched together, e.g., a step having a height of 1 nm or more), it is possible to break down and remove the step bunching. Thereafter, a device fabrication step is performed in which the device fabrication wafer 43 is divided into units of devices, or is processed in accordance with a device to be fabricated, so that a semiconductor device is fabricated.

The basal plane dislocation density reduction step and the activation and planarization step have in common with each other that the wafer is heated under Si vapor pressure, but have different purposes and therefore different processing conditions. More specifically, the temperature in the basal plane dislocation density reduction step is higher than the temperature in the activation and planarization step, because heating at a higher temperature facilitates the reduction of the BPD density more. In the basal plane dislocation density reduction step, the etching is not necessary; in fact, a low etching rate is preferred, because a high-rate etching removes the epitaxial layer wastefully. In the activation and planarization step, on the other hand, a higher etching rate is allowed as compared to in the basal plane dislocation density reduction step, in order to remove the region having the insufficient ion concentration, which is at the depth of about several tens to one hundred nm from the surface. This is why the etching rate in the basal plane dislocation density reduction step is lower than the etching rate in the activation and planarization step. In general, the higher the temperature is, the higher the etching rate is. Accordingly, raising the temperature in the basal plane dislocation density reduction step makes the etching rate higher. Here, a property of the Si vapor pressure etching is that the etching rate is lowered as the inert gas pressure is raised. In this embodiment, therefore, the inert gas pressure in the basal plane dislocation density reduction step is made higher than the inert gas pressure in the activation and planarization step, to thereby achieve both a high temperature and a low etching rate.

The temperature, etching rate, or inert gas pressure in the basal plane dislocation density reduction step may be, for example, the mean value of measured values obtained during the basal plane dislocation density reduction step, or a target value (set value).

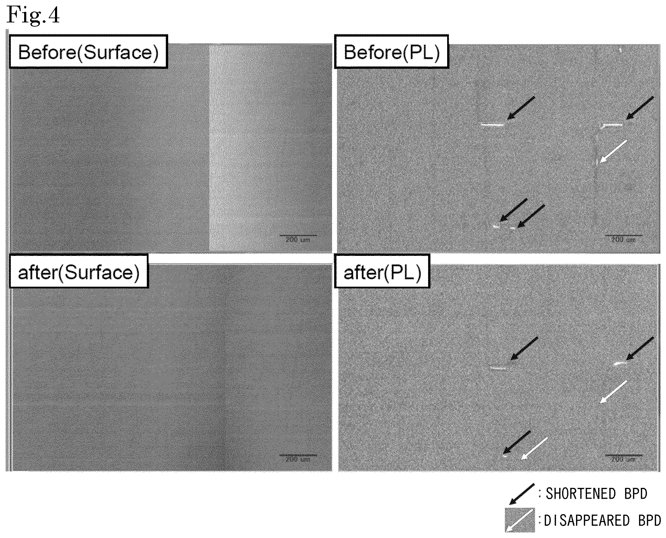

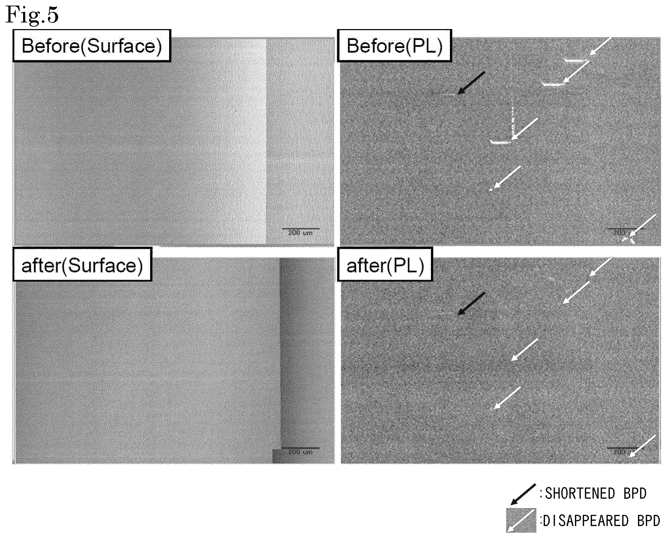

Next, referring to FIG. 4 to FIG. 8, a description will be given to results of experiments in which the basal plane dislocation density reduction step of this embodiment was performed with various conditions changed. In the experiments, PL (photoluminescence) imaging was performed on each of prepared SiC epitaxial wafers 42 before and after the basal plane dislocation density reduction step, and thereby the degree of reduction of BPDs was evaluated.

Each of the SiC epitaxial wafers 42 used in the experiments had an off angle of 4 degrees, had a polymorph of 4H-SiC, and had the epitaxial layer 41 of 10 µm formed on a (0001) Si plane thereof. The SiC epitaxial wafer 42 was doped with nitrogen ions, with a carrier concentration of 1 × 10¹⁶ atoms/cm³. For the PL imaging, SICA88 manufactured by Lasertec Corporation was used with a lamp wavelength of 313 nm and a band-pass filter of 400 nm to 678 nm, to observe BPDs. In the basal plane dislocation density reduction step, the inert gas pressure was 13 kPa, and the processing time was 3 minutes. To examine the relationship between the temperature in the basal plane dislocation density reduction step and the rate of reduction in BPD density, the experiments were performed under different temperatures of 1700°C, 1800°C, 1900°C, 1950°C, 2000°C, and 2050°C.

FIG. 4, FIG. 5, and FIG. 6 are enlarged views showing PL imaging measurement results obtained after the basal plane dislocation density reduction step was performed at 1800°C, 1900°C, and 2000°C, respectively. As can be seen from these views, whether or not a BPD disappeared and whether or not a BPD was shortened can be determined by performing the PL imaging.

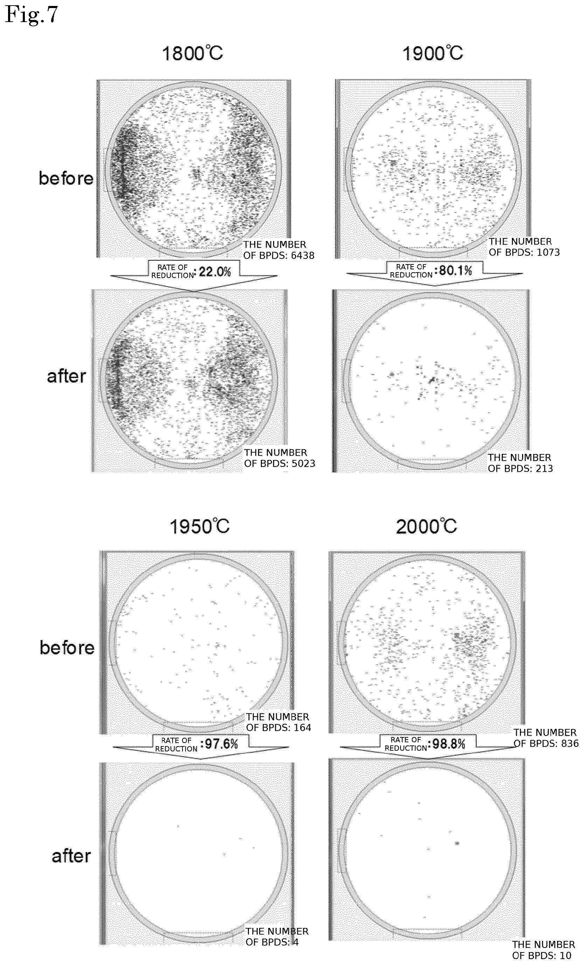

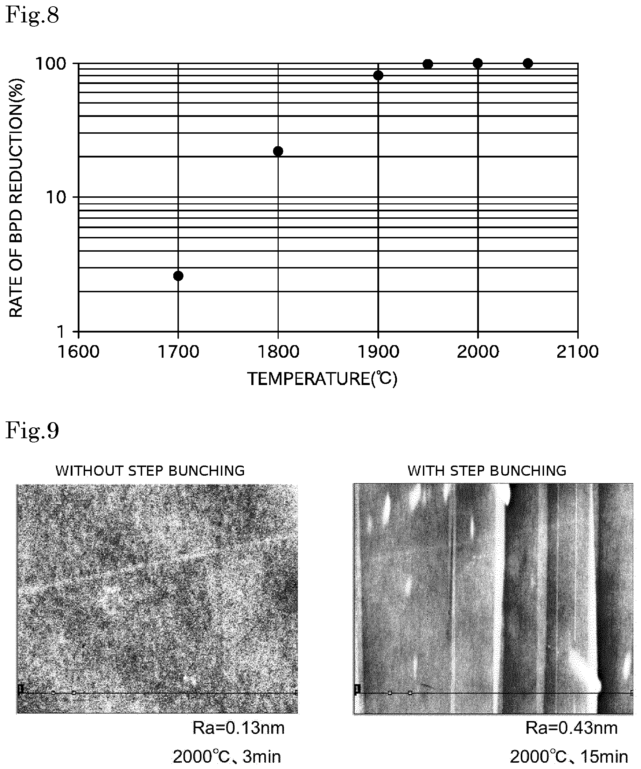

FIG. 7 shows PL imaging measurement results on the entire wafers with respect to four temperatures, namely, 1800°C, 1900°C, 1950°C, and 2000°C. As shown in FIG. 7, the higher the temperature was, the more greatly the number of BPDs was reduced. Especially at a temperature of 1900°C, the number of BPDs was reduced from 1073 to 213, and thus the rate of BPD reduction was 80.1%. At a temperature of 1950°C, the number of BPDs was reduced from 164 to 4, and thus the rate of BPD reduction was 97.6%. At a temperature of 2000°C, the number of BPDs was reduced from 836 to 10, and thus the rate of BPD reduction was 98.8%. FIG. 8 shows the rates of BPD reduction at every temperature adopted in the experiments.

As shown in FIG. 7 and FIG. 8, over 1950°C as a boundary, substantially all BPDs in the wafer disappeared. Accordingly, the basal plane dislocation density reduction step is preferably performed at 1950°C or more, and further preferably at 2000°C or more.

As mentioned above, the BPD in the narrow sense encompasses six types (three types). It is considered that the six types of the BPD in the narrow sense are present with a certain degree of uniformity without a large maldistribution. Since the high rate of BPD reduction, 98.8%, is achieved by the method according to this embodiment, it is obvious that each of the six types of the BPD in the narrow sense is removed by the basal plane dislocation density reduction step of this embodiment. The BPD in the wide sense encompasses four types. The ratios of their presence are not uniform; however, since the high rate of BPD reduction, 98.8%, is achieved by the method according to this embodiment, it can be assumed that each of the four types of the BPD in the wide sense is removed by the basal plane dislocation density reduction step of this embodiment.

Depending on a processing environment and a processing time for the basal plane dislocation density reduction step, a step bunching may be generated on a wafer surface. The step bunching is likely to be generated when, for example, excessive etching is performed under a condition with a too low etching rate (that is, when a long-time process is performed under a condition with a high temperature, or when a long-time process is performed under a condition with a low inert gas pressure, for example). It is preferable that the basal plane dislocation density reduction step is performed with a processing environment and a processing time that do not cause generation of a step bunching.

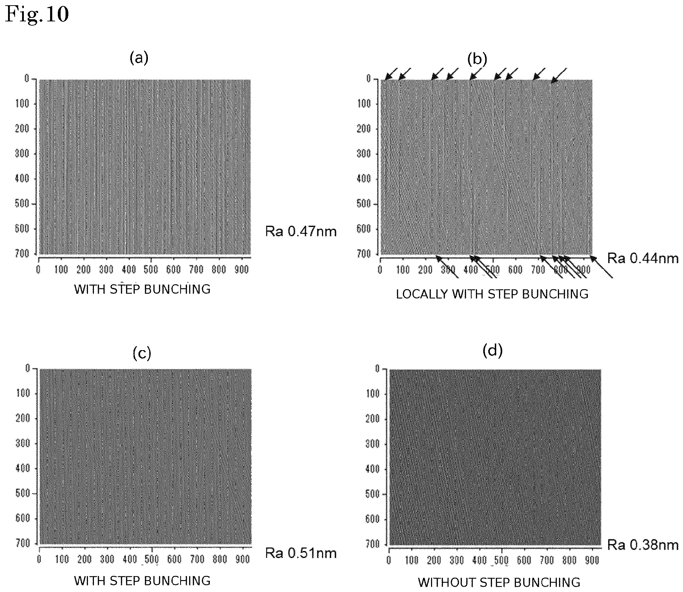

FIG. 9 shows results of observing a surface of a wafer processed with a processing time of 3 minutes as well as a surface of a wafer processed with a processing time of 15 minutes, respectively, under the same conditions as for the experiments described above. In the wafer processed with a processing time of 3 minutes, almost no linear portion can be observed, and thus no or almost no step bunching is present. In the wafer processed with a processing time of 15 minutes, linear portions extending in the vertical direction of the drawing are present, which indicate a step bunching. Generation of a step bunching tends to increase the surface roughness (arithmetic mean roughness Ra). In FIG. 9, the wafer having no step bunching has a surface roughness of 0.13 nm, while the wafer having the step bunching has a surface roughness of 0.43 nm. The basal plane dislocation density reduction step was performed with conditions further changed, and surfaces of wafers were observed and measured for their surface roughnesses. Results of the observation and measurement are shown in FIG. 10. As shown in FIG. 10, when the surface roughness is 0.51 nm or 0.47 nm, a step bunching is generated; when the surface roughness is 0.44 nm, a step bunching is locally generated (at positions indicated by arrows); and when the surface roughness is 0.38 nm, a step bunching is not generated. From this, it can be considered that generation of a step bunching brings the surface roughness to more than 0.4 nm. Accordingly, "a processing environment and a processing time that do not cause generation of a step bunching after the basal plane dislocation density reduction step" is almost the same as "a processing environment and a processing time that bring the surface roughness to 0.4 nm or less after the basal plane dislocation density reduction step".

A larger thickness of the epitaxial layer makes surface roughening of the wafer more likely to occur. In this regard, however, the applicant has confirmed that the likelihood of occurrence of surface roughening does not largely change with thicknesses (10 µm, 30µm) that are generally employed at present. Even though an epitaxial layer having another thickness is formed, setting a processing environment and a processing time that bring the surface roughness to 0.4 nm or less after the basal plane dislocation density reduction step makes it possible to sufficiently reduce BPDs while suppressing surface roughening such as a step bunching. Depending on a required wafer quality, etc., it is preferable to set a processing environment and a processing time that bring the surface roughness to 0.1 nm or less, 0.2 nm or less, or 0.3 nm or less after the basal plane dislocation density reduction step.

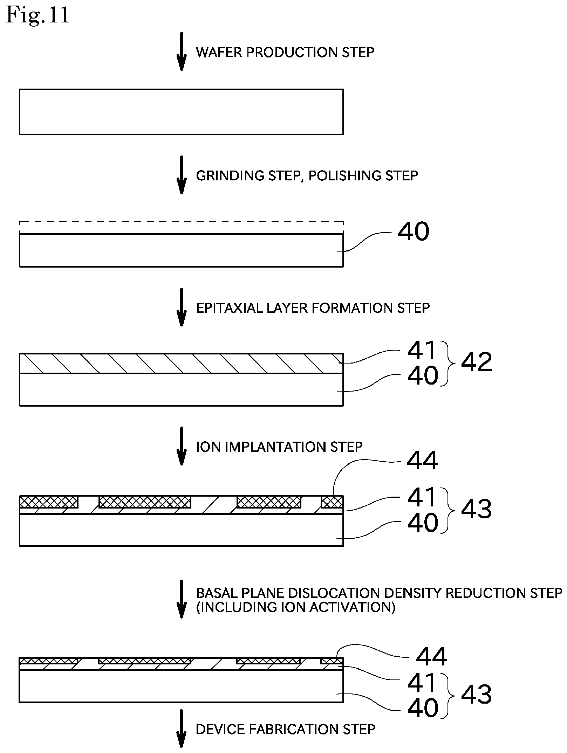

Next, referring to FIG. 11, a variation will be described in which the basal plane dislocation density reduction step and the activation and planarization step are performed concurrently. In the embodiment, the ion implantation step is preceded by the basal plane dislocation density reduction step, while in this variation, the ion implantation step is followed by the basal plane dislocation density reduction step. In the embodiment, the basal plane dislocation density reduction step and the activation and planarization step have different purposes and different conditions, but both of them are implemented by heating under Si vapor pressure. In this variation, therefore, the basal plane dislocation density reduction step and the activation and planarization step are performed concurrently. This can reduce the number of steps, and consequently can reduce a manufacturing time and a manufacturing cost.

Even if a timing when the basal plane dislocation density reduction step is performed is changed, the preferable processing conditions and the achieved surface roughness are the same as those of the embodiment. Thus, in this variation, too, the basal plane dislocation density reduction step is preferably performed at 1950°C or more, and further preferably at 2000°C or more. In this variation, too, a surface roughness of 0.4 nm or less can be obtained.

Next, a description will be given to an influence that the amount of implanted ions in the ion implantation step and the heating temperature in activation have on the surface roughness of the wafer. According to NPL 1, the larger the amount of implanted ions is, the higher the surface roughness becomes after activation. NPL 1 shows lowering the surface roughness after activation by forming a carbon cap, but also shows data indicating that the surface roughness (Rms) exceeds 0.4 nm in a case of a large amount of implanted ions, for example. It therefore is demanded that the surface roughness after activation be improved.

The inventors of the present application noticed that the wafer prepared by the method according to the embodiment and variation has a low surface roughness, and conducted experiments to inspect an influence that the amount of implanted ions and the heating temperature in activation have on the surface roughness. To be specific, the inventors performed activation while varying the amount of implanted ions and the heating temperature, and measured the surface roughness after the activation. These experiments were conducted with respect to both the conventional method using a carbon cap and the method (heating under Si vapor pressure) according to the embodiment and variation, and results were compared against each other. In a case of using the carbon cap method, the surface roughness after removal of the carbon cap was measured.

The heating temperature in activation is, in the embodiment, a heating temperature in the activation and planarization step, and in the variation, a heating temperature in the basal plane dislocation density reduction step. The amount of implanted ions means the number of ions implanted per unit area. Thus, the amount of implanted ions can be also referred to as ion implantation density.

Heating conditions in the experiments were as follows: four temperatures in a range of 1700°C to 2000°C were adopted as the heating temperatures in activation; the heating period was 2 minutes; and the pressure was 13 kPa (Ar atmosphere). Each wafer used in the experiments was: having a polymorph of 4H-SiC; having an off angle of 4 degrees; having an Si plane serve as the principal plane; already polished by chemical-mechanical polishing; and having an epitaxial layer (n-type 1 × 10¹⁶/cm³) of 10 µm. The ion implantation was performed as follows: Al ions were multi-stage implanted while the wafer temperature was 500°C; and four values in a range of 1 × 10¹⁴ atoms/cm² to 1×10¹⁶ atoms/cm² were adopted as the amounts of implanted ions. The surface roughness was evaluated by using a coherence scanning interferometer (CSI).

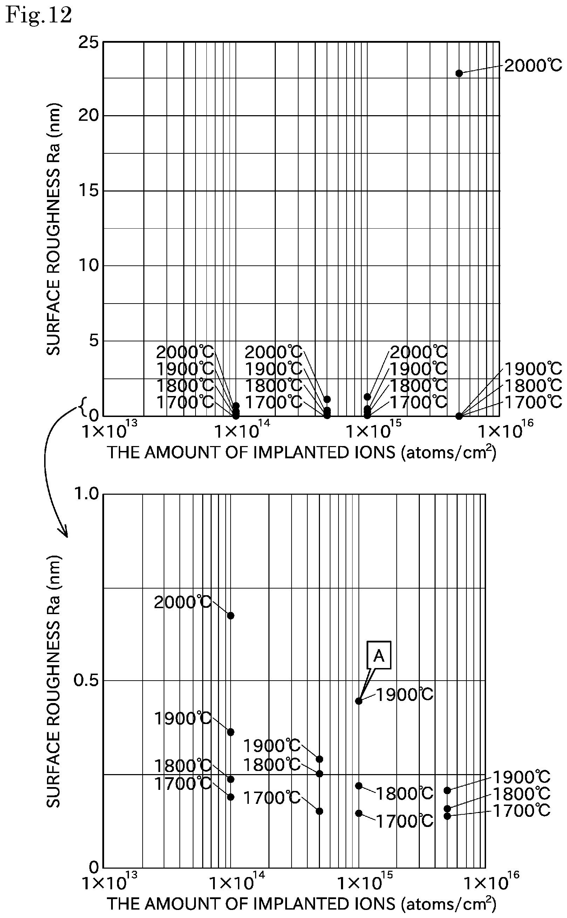

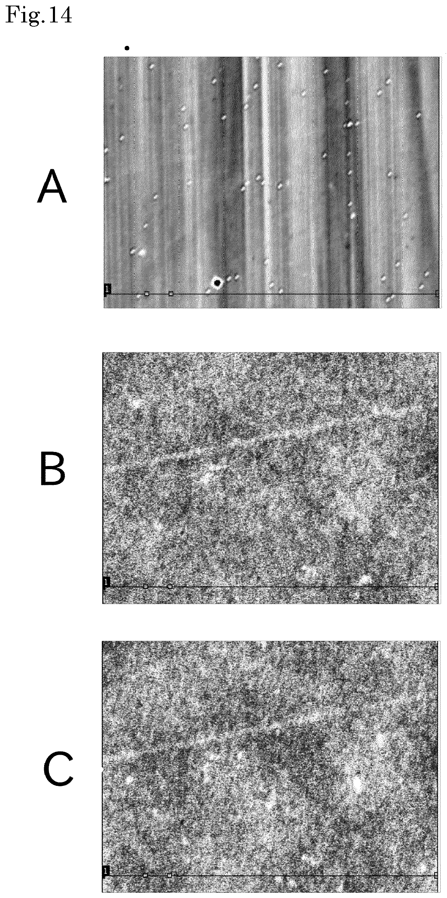

FIG. 12 is graphs showing results of experiments in which activation was performed by using the carbon cap method. In the graphs of FIG. 12, the horizontal axis represents the amount of implanted ions, and the vertical axis represents the surface roughness (Ra). Temperatures indicated at respective plots of the graphs are heating temperatures in activation. The lower graph is a graph obtained by changing the scale of the vertical axis of the upper graph. As shown in FIG. 12, basically, the surface roughness increases as the heating temperature rises. Especially when the heating temperature is 2000°C, the surface roughness is particularly high. As for the amount of implanted ions, for example, when the heating temperature is 2000°C, the surface roughness increases as the amount of implanted ions increases. Especially when the amount of implanted ions is 5 × 10¹⁵ atoms, the surface roughness is very high. Even when the heating temperature is 1900°C, the surface roughness exceeds the above-mentioned value, 0.4 nm, and a step bunching is generated, under the condition of 1 × 10¹⁵ atoms (see A of FIG. 14). In consideration of these results and the data shown in NPL 1, there is a possibility that the surface roughness becomes high when the heating temperature is a high temperature (e.g., 1900°C or more) and the amount of implanted ions is large (e.g., more than 1 × 10¹⁵ atoms). Since these processing conditions may not satisfy the specifications required for fabrication of a semiconductor device, these processing conditions cannot be acutally adopted, and lowering the heating temperature or reducing the amount of implanted ions is unavoidable.

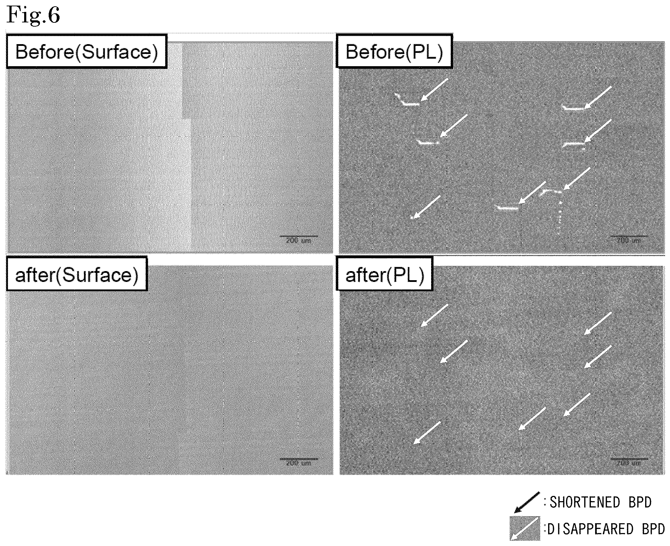

Example 1 of PTL 2 states that the condition regarding the amount of implanted ions is "1 × 10¹⁹ atoms/cm³, at 500 nm from the wafer surface". The amount of implanted ions is, strictly, expressed in the unit of "atoms/cm²", which represents the amount of implanted atoms per area, but it may sometimes be expressed in the unit of "atoms/cm³", which represents the amount of implanted atoms per volume. The condition stated in PTL 2, that ions of 1 × 10¹⁹ atoms/cm³ are implanted at 500 nm from the wafer surface, is turned into 5 × 10¹⁴ atoms/cm² as a result of unit conversion. Thus, there is a possibility that surface roughening attributable to the amount of implanted ions does not occur if the amount of implanted ions stated in PTL 2 is adopted. Although FIG. 6 of PTL 2 shows a wafer having a surface roughness of 0.4 nm or less, FIG. 6 shows results of experiments in a case of using a wafer having an off angle of 0°. A wafer having an off angle of 0° and a wafer having an off angle are different from each other in terms of conditions for reducing the surface roughness. Therefore, even though the same process as in PTL 2 is performed, the same degree of surface roughness may not be obtained with a wafer having an off angle of 0°.

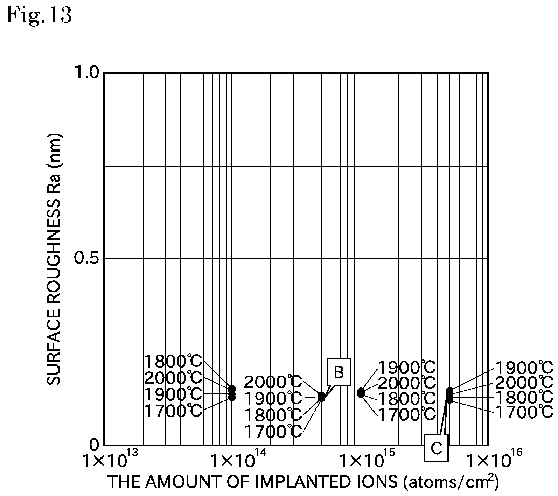

FIG. 13 is a graph showing results of experiments in which activation was performed by using the method according to the embodiment and variation. As shown in this graph, a sufficiently low surface roughness (0.4 nm or less) can be obtained irrespective of the heating temperature and the amount of implanted ions. A step bunching is not generated in any of cases (for example, see B and C of FIG. 13 and FIG. 14). Accordingly, performing activation by using the method according to the embodiment and variation provides a sufficiently low surface roughness, even under processing conditions that would cause a high surface roughness and therefore could not be adoptable conventionally. As a result, the process can be performed at a high heating temperature or with a large amount of implanted ions. If activation is performed at a high heating temperature, a wafer having good electrical characteristics can be produced. Specifically, a low sheet resistance, a high electron mobility, and a high channel mobility can be achieved.

The amount of implanted ions varies depending on a manufacturer, device characteristics, and the like. The method according to the embodiment and variation is versatile, covering not only a large amount of implanted ions but also a small amount of implanted ions.

As described above, the basal plane dislocation density reduction step is preferably performed at 1950°C or more. If activation is performed concurrently with the basal plane dislocation density reduction step by using the carbon cap method, a heating temperature of 1950°C or more may make the surface roughness very high. In the variation shown in FIG. 11, the surface roughness does not become high even at 1950°C or more. Accordingly, the variation can simultaneously achieve all of a reduced number of steps, a low basal plane dislocation density, a low surface roughness, and improved electrical characteristics.

A wafer manufactured by the method according to the embodiment and variation is particularly useful to manufacture MOS (Metal Oxide Semiconductor) type devices or Schottky diodes. Specifically, in a MOS type device, the required amount of implanted ions varies from region to region. Thus, the method, which can cover various amounts of implanted ions, can be used effectively. A wafer produced by the method has a low surface roughness, and in other words, has a reduced step bunching. The step bunching makes the thickness of an oxide film uneven during formation of the oxide film. More specifically, an electric field concentration, which leads to a failure of a MOS device or a Schottky diode, is likely to occur at the boundary between a portion having a small film thickness and a portion having a large film thickness in the vicinity of a portion where the step bunching is generated. The wafer (or a chip fabricated by dividing the wafer) of the embodiment and variation, which has less step bunching, is particularly suitable for manufacturing of a MOS device or a Schottky diode with a high reliability. As mentioned above, the wafer has good electrical characteristics. In this point as well, the wafer is suitable for manufacturing a MOS device or a Schottky diode with a high reliability. To be specific, use of the wafer makes it possible to manufacture a MOS device or a Schottky diode having a low sheet resistance, a high electron mobility, and a high channel mobility.

As thus far described, in the method for manufacturing the device fabrication wafer 43 according to the embodiment or variation, the SiC epitaxial wafer 42 that is the SiC wafer 40 having the monocrystalline SiC epitaxial layer 41 formed thereon is subjected to the basal plane dislocation density reduction step of reducing the density of basal plane dislocations existing in the epitaxial layer of the SiC epitaxial wafer 42, to thereby manufacture the device fabrication wafer 43 for use to fabricate a semiconductor device. In the basal plane dislocation density reduction step, the SiC epitaxial wafer 42 is heated under Si vapor pressure for a predetermined time necessary to reduce the density of basal plane dislocations, without formation of a cap layer on the SiC epitaxial wafer 42, so that the density of basal plane dislocations is reduced with suppression of surface roughening.

Since the SiC epitaxial wafer 42 is heated under Si vapor pressure, surface roughening is less likely to occur. A cap layer is not necessary in the basal plane dislocation density reduction step, therefore. Accordingly, steps related to formation and removal of a cap layer can be eliminated, while surface roughening can be suppressed.

The method for manufacturing the device fabrication wafer 43 according to the embodiment includes the ion implantation step, and the activation and planarization step. In the ion implantation step, ions are implanted in the SiC epitaxial wafer 42. In the activation and planarization step, the SiC epitaxial wafer 42 having been implanted with the ions in the ion implantation step is heated under Si vapor pressure, so that the ions are activated while surface roughening of the SiC epitaxial wafer 42 is suppressed. The basal plane dislocation density reduction step is a step separate from the activation and planarization step.

With this, the basal plane dislocation density reduction step can be performed under conditions particularly suitable for removal of basal plane dislocations. Activation by heating under Si vapor pressure is performed after ion implantation. Accordingly, even with a large amount of implanted ions or a high heating temperature in activation, it is possible to improve electrical characteristics with suppression of increase of surface roughness.

In the method for manufacturing the device fabrication wafer 43 according to the embodiment, the basal plane dislocation density reduction step is performed before the ion implantation step.

Since the basal plane dislocation density reduction step is performed before properties of the epitaxial layer 41 are changed by ion implantation, basal plane dislocations can be removed further reliably.

In the method for manufacturing the device fabrication wafer 43 according to the embodiment, the temperature in the basal plane dislocation density reduction step is higher than the temperature in the activation and planarization step.

Accordingly, the basal plane dislocation density reduction step can be performed at a relatively high temperature that is adapted for sufficient reduction of the density of basal plane dislocations.

In the method for manufacturing the device fabrication wafer 43 according to the embodiment, the etching rate in the basal plane dislocation density reduction step is lower than the etching rate in the activation and planarization step.

This can prevent excessive removal of the epitaxial layer 41 of the SiC epitaxial wafer 42 in the basal plane dislocation density reduction step.

In the method for manufacturing the device fabrication wafer 43 according to the variation, activating the ions implanted in the ion implantation step while planarizing the surface of the SiC epitaxial wafer 42 is performed in the basal plane dislocation density reduction step.

This can reduce the number of steps. In addition, activation by heating under Si vapor pressure is performed after ion implantation. Accordingly, even with a large amount of implanted ions or a high heating temperature in activation, it is possible to improve electrical characteristics with suppression of increase of surface roughness.

In the method for manufacturing the device fabrication wafer 43 according to the embodiment or variation, it is preferable that the SiC epitaxial wafer 42 has an off angle of 4 degrees or less relative to the <11-20> direction or the <1-100> direction.

This can more reliably suppress an increase in surface roughness at a time of ion activation.

In the method for manufacturing the device fabrication wafer 43 according to the embodiment or variation, the temperature in the basal plane dislocation density reduction step is 1950°C or more and 2200°C or less.

This allows the density of basal plane dislocations to be reduced sufficiently.

In the method for manufacturing the device fabrication wafer 43 according to the embodiment or variation, the basal plane dislocation density reduction step is performed with a processing environment and a processing time that bring the surface roughness (Ra) of the device fabrication wafer to 0.4 nm or less after the basal plane dislocation density reduction step.

This makes it highly likely that a step bunching is not generated on the device fabrication wafer 43, and thus the device fabrication wafer 43 with a high quality can be manufactured.

In the method for manufacturing the device fabrication wafer 43 according to the embodiment or variation, the density of basal plane dislocations in the epitaxial layer of the SiC epitaxial wafer 42 is reduced by 97% or more as a result of the basal plane dislocation density reduction step.

Accordingly, the device fabrication wafer 43 having a very small amount of basal plane dislocations can be manufactured.

While a preferred embodiment of the present invention has been described above, the configurations given above can be modified, for example, as follows.

The manufacturing steps described in the embodiment are an example. It is possible to change the order of the steps, to omit a part of the steps, or to add another step. For example, as described with reference to FIG. 11, the basal plane dislocation density reduction step may be performed after the ion implantation step. In such a case, for example, the activation and planarization step and the basal plane dislocation density reduction step may be performed concurrently.

The above-described temperature condition, pressure condition, and the like, are merely examples, and may be changed as appropriate. It is acceptable to use a heating apparatus different from the above-described high temperature vacuum furnace 10, to use a polycrystalline SiC wafer 40, or to use a container whose shape or material is different from that of the receiving container 30. For example, the outer shape of the receiving container is not limited to a columnar shape, but may be a cubic shape or a rectangular parallelepiped shape.

### Reference Signs List

- 10: high temperature vacuum furnace
- 40: SiC wafer
- 41: epitaxial layer
- 42: SiC epitaxial wafer
- 43: device fabrication wafer

## Claims

1. A method for manufacturing a device fabrication wafer for use to fabricate a semiconductor device, by subjecting an SiC epitaxial wafer that is an SiC wafer having a monocrystalline SiC epitaxial layer formed thereon to a basal plane dislocation density reduction step of reducing the density of basal plane dislocations existing in the epitaxial layer of the SiC epitaxial wafer, wherein
in the basal plane dislocation density reduction step, the SiC epitaxial wafer is heated under Si vapor pressure for a predetermined time necessary to reduce the density of basal plane dislocations, without formation of a cap layer on the SiC epitaxial wafer, so that the density of basal plane dislocations is reduced with suppression of surface roughening.

2. The method for manufacturing the device fabrication wafer according to claim 1, the method comprising:
an ion implantation step of implanting ions in the SiC epitaxial wafer; and
an activation and planarization step of heating, under Si vapor pressure, the SiC epitaxial wafer having been implanted with the ions in the ion implantation step, to activate the ions as well as to planarize a surface of the SiC epitaxial wafer,
the basal plane dislocation density reduction step being a step separate from the activation and planarization step.

3. The method for manufacturing the device fabrication wafer according to claim 2, wherein
the basal plane dislocation density reduction step is performed before the ion implantation step.

4. The method for manufacturing the device fabrication wafer according to claim 2, wherein
a temperature in the basal plane dislocation density reduction step is higher than a temperature in the activation and planarization step.

5. The method for manufacturing the device fabrication wafer according to claim 2, wherein
an etching rate in the basal plane dislocation density reduction step is lower than an etching rate in the activation and planarization step.

6. The method for manufacturing the device fabrication wafer according to claim 1, comprising an ion implantation step of implanting ions in the SiC epitaxial wafer, wherein
the basal plane dislocation density reduction step is performed after the ion implantation step, and
in the basal plane dislocation density reduction step, activation of the ions implanted in the ion implantation step as well as planarization of a surface of the SiC epitaxial wafer is further performed.

7. The method for manufacturing the device fabrication wafer according to claim 2, wherein
the SiC epitaxial wafer has an off angle of 4 degrees or less relative to the <11-20> direction or the <1-100> direction.

8. The method for manufacturing the device fabrication wafer according to claim 1, wherein
a temperature in the basal plane dislocation density reduction step is 1950°C or more and 2200°C or less.

9. The method for manufacturing the device fabrication wafer according to claim 1, wherein
the basal plane dislocation density reduction step is performed with a processing environment and a processing time that bring a surface roughness (Ra) of the device fabrication wafer to 0.4 nm or less after the basal plane dislocation density reduction step.

10. The method for manufacturing the device fabrication wafer according to claim 1, wherein
as a result of the basal plane dislocation density reduction step, the density of basal plane dislocations in the epitaxial layer of the SiC epitaxial wafer is reduced by 97% or more.
